# EUROPÄISCHE PATENTSCHRIFT

(11) **EP 0 829 015 B1**
(45) Veröffentlichungstag und Bekanntmachung des Hinweises auf die Patenterteilung: **25.11.1998**
(21) Anmeldenummer: 96919572.6
(22) Anmeldetag: 23.05.1996
(51) Int. Cl.: G01R 31/12

(54) **ÜBERWACHUNGSVERFAHREN FÜR EINE KONDENSATORDURCHFÜHRUNG UND EINE ÜBERWACHUNGSANORDNUNG HIERZU**
MONITORING PROCESS FOR A CAPACITOR LEAD-THROUGH AND A MONITORING SYSTEM THEREFOR
PROCEDE DE SURVEILLANCE POUR TRAVERSEE DE CONDENSATEUR ET SYSTEME DE SURVEILLANCE APPROPRIE

(30) Priorität: 24.05.1995 DE 19519230
(43) Veröffentlichungstag der Anmeldung: 18.03.1998
(73) Patentinhaber: HSP Hochspannungsgeräte Porz GmbH, 51145 Köln (DE)
(72) Erfinder: FRIELINGSDORF, Helmut, D-51469 Bergisch Gladbach (DE)
(74) Vertreter: Epping, Wilhelm, Dr.-Ing.
(86) Internationale Anmeldenummer: DE9600901
(87) Internationale Veröffentlichungsnummer: WO9637787

(56) Entgegenhaltungen:
- DE-A- 3 601 934
- US-A- 3 882 378
- US-A- 4 757 263

## Beschreibung

Die Erfindung betrifft eine Überwachungsanordnung für eine Kondensatordurchführung mit Kondensatoreinlagen und eine nach dem Verfahren arbeitende Überwachungsannordnung.

Aus der DE 36 01 934 A1 ist eine permanent überwachte Kondensatordurchführungs-Anordnung für Großtransformatoren in Drehstromnetzen bekannt. Dort ist bei einer mehrphasigen Kondensatordurchführung für jede Phase ein Abgriff zwischen den Kondensatoreinlagen vorgesehen, so daß eine Teilspannung abgreifbar ist. Die Teilspannungen werden dann einer Brückenschaltung zugeführt, an die eine Meßeinrichtung angeschlossen ist. Bei einem Fehler, insbesondere einem Kurzschluß zwischen einzelnen Kondensatoreinlagen, in einer der Phasen der Kondensatordurchführung wird eine Fehlspannung von der Meßeinrichtung erfaßt und ein Fehlersignal erzeugt. Diese Art der Überwachung eignet sich, um grobe Fehler innerhalb einer mehrphasigen Kondensatordurchführung zu erfassen. Kleine Fehler, die unter Umständen zunächst keine Beeinträchtigung des Betriebsverhaltens haben, können hiermit nicht erkannt werden.

Der Erfindung liegt die Aufgabe zugrunde, die Überwachung für eine Kondensatordurchführung gegenüber dem Stand der Technik zu verbessern, wobei auch kleine Fehler berücksichtigt werden sollen. Hierzu ist ein Verfahren und eine geeignete Anordnung anzugeben.

Die Lösung der Aufgabe bezüglich des Verfahrens gelingt erfindungsgemäß mit einem Überwachungsverfahren für eine Kondensatordurchführung, die zwischen ihren Kondensatoreinlagen einen Abgriff für eine Teilspannung aufweist, wobei die Teilspannung einer Erfassungseinrichtung zugeführt wird, welche die Teilspannung auf eine Änderung hin überwacht,
- wobei eine Änderung der Teilspannung und eine Zeitinformation hierzu gespeichert werden,
- wobei der zeitliche Abstand zwischen zumindest zwei Änderungen ermittelt wird und
- wobei ein der Häufigkeit der Teilspannungsänderungen entsprechendes Fehlersignal erzeugt wird.

Auf diese Weise kann je nach Wichtigkeit des Fehlers eine entsprechende Warnung zur elektrischen Überwachung für das Bedienpersonal abgegeben werden. Ein einfacher Teildurchschlag zwischen zwei Kondensatoreinlagen muß nämlich noch keine Beeinträchtigung des Betriebes darstellen. Die Tatsache an sich, daß nämlich ein Durchschlag stattgefunden hat, kann jedoch für das Betriebspersonal bereits von Interesse sein. Es wird daher beispielsweise eine einfache Meldung abgegeben. Eine Stör- oder Warnsignalisierung erfolgt dann gestaffelt. Das Fehlersignal beeinhaltet somit eine quantitative und qualitative Aussage. Obwohl die jeweiligen Änderungen ggf. gleich sind, kann eine unterschiedliche Signalisierung erfolgen. Das Verfahren ist bei Durchführungen beliebiger Phasenanzahl, insbesondere bei 1- und 3-phasigen, anwendbar.

Mit Vorteil kann die Änderung der Teilspannung nach Überschreiten eines vorgegebenen Grenzwertes gespeichert werden. Dadurch werden Änderungen, z.B. geringfügige Störspannungen, die nicht eine vorgegebene Höhe erreichen, nicht gewertet.

Das Fehlersignal kann auch nach einer vorgegebenen gewichteten Bewertung der gespeicherten Änderungen mit Hilfe eines Fuzzy-Gliedes erzeugt werden. Auf diese Weise ist auch eine Erkennung von kritischen oder untypischen Fehlersituationen schnell möglich.

In der Erfassungseinrichtung können kann als Zeitinformation der Enstehungszeitpunkt der Änderung und/oder die Differenzzeit zwischen zwei Änderungen gespeichert sein. In jedem Fall ist eine genaue Ermittlung der Häufigkeit möglich.

Die Überwachung der Teilspannung erfolgt bevorzugt je Phase der Kondensatordurchführung. Damit kann die gesamte Überwachung ein- oder mehrphasig ausgebildet sein, was einer selektiven Fehlererfassung entgegenkommt.

Es kann auch ein Abbild der erfaßten Änderungshäufigkeit mit einem abgespeicherten Abbild für einen Fehlerfall verglichen werden und bei zumindest teilweiser Übereinstimmung das Fehlersignal erzeugt werden. Dadurch können auch spezielle Fehler, die nur schwer zu erfassen sind, sicher erkannt werden. Die Abbilder können in Speichern der Erfassungseinrichtung abgelegt sein.

Die Lösung der Aufgabe bezüglich der Anordnung gelingt erfindungsgemäß mit einer Überwachungsanordnung für eine Kondensatordurchführung, die zwischen ihren Kondensatoreinlagen einen Abgriff für eine Teilspannung aufweist, umfassend
- eine Erfassungseinrichtung, in der die Teilspannung auf eine Änderung hin überwacht wird, gekennzeichnet durch
- einen Speicher, in dem eine Änderung der Teilspannung und eine Zeitinformation hierzu hinterlegt werden,
- ein Rechenglied, mit dem der zeitliche Abstand zwischen zumindest zwei Änderungen ermittelt wird, und
- Mittel zum Erzeugen eines Fehlersignals, wobei ein der Häufigkeit der Teilspannungsänderungen entsprechendes Fehlersignal erzeugt wird.
Eine solche Überwachungsanordnung läßt eine sichere und zuverlässige Überwachung zu, wobei gleiche Änderungen der Teilspannung je nach zeitlichem Verhalten unterschiedlich bewertet werden.

Bevorzugt weist die Erfassungseinrichtung Mittel zur optischen und /oder elektrischen Ausgabe des Fehlersignals auf. Die Mittel können beispielsweise als Schnittstelle oder als Anzeigemittel ausgebildet sein. Auf diese Weise kann ein Fehler dem Betriebspersonal auf die jeweils günstigste Art zur Kenntnis gebracht werden.

Mit Vorteil ist ein Grenzwertglied vorgesehen, wobei die Speicherung der Änderung der Teilspannung nach Überschreiten eines vorgegebenen Grenzwertes erfolgt. Damit ist eine Grobauswahl der erfaßten Änderungen möglich.

Vorteilhafterweise kann ein Fuzzy-Glied vorgesehen sein, wobei das Fehlersignal nach einer vorgegebenen Gewichtung oder Bewertung der gespeicherten Änderungen erzeugt wird. Dadurch ist eine besonders schnelle und sichere Fehlerdetektion möglich.

Die Erfassungsanordnung ist mit Vorteil mehrphasig, insbesondere dreiphasig, ausgeführt. Dabei ist eine selektive Fehlererkennung gegeben.

Die Erfassungseinrichtung, insbesondere das Rechenglied, kann als analoge oder digitale Schaltung, z.B. mit einem Prozessor, ausgeführt sein. Ggf. können für eine digitale Meßwertverarbeitung A/D-Wandler oder auch digitale Signalprozessoren zur Anwendung kommen.

Eine alternative Lösung der Aufgabe bezüglich des Verfahrens ist mit einem Überwachungsverfahren für eine Kondensatordurchführung gegeben, welche zwischen ihren Kondensatoreinlagen einen Abgriff für eine Teilspannung aufweist, wobei die Teilspannung einer Erfassungseinrichtung zugeführt ist, welche die Teilspannung auf eine Änderung hin überwacht, wobei Änderungen der Teilspannung gezählt werden und nach einer vorgegebenen Anzahl von Änderungen ein Fehlersignal erzeugt wird. Diese Lösung ist besonders einfach und läßt sich ggf. bei bestehenden Einrichtungen nachrüsten.

Das Fehlersignal wird bevorzugt erst nach Auftreten der Änderungen in einem vorgegebenen Zeitraum erzeugt. Damit liegt der Signalisierung eine Information über die Häufigkeit der Änderungen zugrunde.

Die Zählung einer Änderung der Teilspannung kann nach Überschreiten eines vorgegebenen Grenzwertes erfolgen. Auf diese einfache Weise sind Störungen durch Störspannungen ausgeschlossen.

Eine weitere Lösung bezüglich der Anordnung ist gegeben durch eine Überwachungsanordnung für eine Kondensatordurchführung, die zwischen ihren Kondensatoreinlagen einen Abgriff für eine Teilspannung aufweist, mit
- einer Erfassungseinrichtung, in der die Teilspannung auf eine Änderung hin überwacht wird, gekennzeichnet durch
- eine Zähleinrichtung, mit der Änderungen der Teilspannung gezählt werden, und
- Mittel zum Erzeugen eines Fehlersignals, wobei das Fehlersignal nach Überschreiten einer vorgegebenen Anzahl von Anderungen erzeugt wird.

Diese Anordnung ist sehr einfach im Aufbau und läßt sich mit wenig Aufwand realisieren.

Die Druckschrift US-A-3882378 beschreibt eine Überwachungsvorrichtung für eine Hochspannungsleitung. Diese Vorrichtung zeigt die an den einzelnen Isolatoren der Hochspannungsleitung stattfindenden Überschläge an und zählt sie.

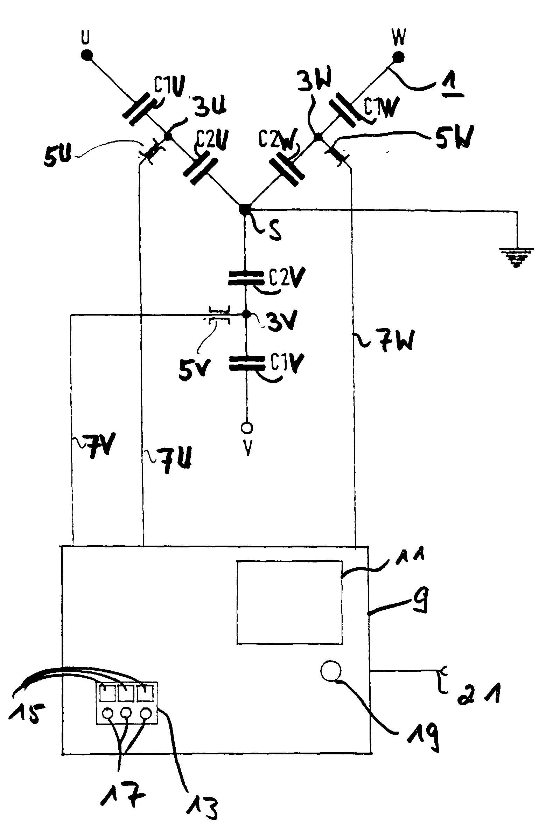

Die Erfindung, weitere Vorteile und Details werden nachfolgend anhand der Zeichnung beispielhaft näher erläutert.

Die Figur zeigt eine dreiphasige Kondensatordurchführung 1 in ihrem elektrischen Ersatzschaltbild. Die nachfolgenden Ausführungen beziehen sich beispielhaft für die Gesamt funktion nur auf die Phase W der Kondensatordurchführung 1. Alle Angaben und Details gelten daher sinngemäß auch für die übrigen Phasen oder auch für Anordnungen mit hiervon abweichender Phasenanzahl.

Derartige Kondensatordurchführungen werden beispielsweise bei hohen Spannungen, die im Bereich von einigen kV bis zu eini-gen 1000 kV liegen können, eingesetzt. Eine spezielle Ausführung ist die Transformatordurchführung, bei der auf geringstem Raum eine Beherrschung der hohen Spannungen ermöglicht ist. Andere Anwendungen, z. B. als Durchführung für Gebäudewände oder an gekapselten Gehäusen, insbesondere SF6-Kapselungen, sind auch möglich.

Die gezeigte Kondensatordurchführung 1 ist rein beispielhaft dreiphasig ausgestaltet. Abweichende Phasenzahlen, z.B. eine einphasige Ausführung, sind möglich. Selbstverständlich kann mechanisch je Phase eine getrennte Durchführung vorgesehen sein, die zusammen elektrisch eine dreiphasige Anordnung ergeben.

Zur Feldsteuerung weist die Kondensatordurchführung 1 in ihrem Inneren nicht näher gezeigte Kondensatoreinlagen nach dem Stand der Technik auf, die elektrisch gesehen eine Reihenschaltung von Kondensatoren bilden. Der Sternpunkt S kann geerdet sein, wobei die Erdung vorliegend als gemeinsame Rückleitung für die drei Phasen gilt.

Zwischen vorgegebenen Kondensatoreinlagen ist ein Abgriff 3W vorgesehen. Der Abgriff 3W ist je nach gewünschter Teilspannung nach Art eines Spannungsteilers vorgegeben. Dadurch ist im elektrischen Ersatzschaltbild ein kapazitiver Spannungsteiler mit einem ersten Kondensator C1W und einem zweiten Kondensator C2W gebildet. Der Abgriff 3W ist über eine Meßdurchführung 5W oder auch durch eine andere geeignete elektrische Isolation mittels einer Meßleitung 7W an eine Erfassungseinrichtung 9 geführt. Der Abgriff 3W liefert eine Teilspannung, die ein Abbild der am Inneren der Kondensatordurchführung 1 - hier dem Anschlußpunkt W entsprechend - anliegenden Hochspannung entspricht.

Eine solche Kondensatordurchführung kann beispielsweise etwa ca. 10 bis mehrere 100 Kondensatoreinlagen enthalten. Dabei kann es vorkommen, daß ein elektrischer Überschlag zwischen zwei Einlagen auftritt, der einen Kurzschluß zwischen den Einlagen darstellt. Ein einmaliger oder wenige Teildurchschläge muß bzw. müssen in der Regel noch keine Gefahr für den Betrieb der Kondensatordurchführung 1 darstellen. Dieser Schadensmechanismus geht jedoch in der Regel lawinenartig vonstatten. Das heißt, daß die Zeitspanne zwischen zwei Durchschlägen mit der Häufigkeit der Durchschläge verkürzt wird.

Hier setzt die neue Idee an, nach der verfahren wird: Die Erfassungseinrichtung 9 erfaßt mit der abgegriffenen Teilspannung die jeweiligen Durchschlagsereignisse, die als geringer Spannungssprung verzeichnet werden und speichert diese Änderungen und eine Zeit information hierzu, insbesondere den Ereigniszeitpunkt, in einem nicht näher gezeigten Speicher ab. Es kann dabei wahlweise die Höhe der Spannungsänderung oder auch nur eine Information über das Vorhandensein des Ereignisses abgespeichert werden. Zwischen der Höhe des Spannungssprunges und der Anzahl der kurzgeschlossenen Kondensatoreinlagen besteht in der Regel ein direkter Zusammenhang, der in der Praxis bekannt ist oder dessen Verhältnis abgeschätzt werden kann.

Mit Hilfe eines nicht näher gezeigten Rechengliedes, beispielsweise ein Prozessor, wird in der Erfassungseinrichtung 9 der zeitliche Abstand zwischen den jeweiligen Änderungen ermittelt, wobei die Häufigkeit der Änderungen eine Aussage über die Betriebszuverlässigkeit der Kondensatordurchführung 1 zuläßt. Der zeitliche Abstand kann ebenfalls in einem Speicher hinterlegt werden.

In der Erfassungseinrichtung 9 wird dann je nach Gefährlichkeit der Über- oder Durchschläge, insbesondere nach deren Häufigkeit, mit einem geeigneten Mittel ein entsprechend gewichtetes Meldungs- oder Fehlersignal erzeugt. Dieses kann beispielsweise im Anfangsstadium - also bei dem ersten überhaupt bei der Kondensatordurchführung auftretenden Durchschlag - als Überschlagsmeldung, in einem mittleren Stadium als Warnmeldung oder in einem Endstadium, in dem die Betriebssicherheit gefährdet ist, als Abschaltsignal für die Hochspannungsbetriebsmittel ausgestaltet sein. Unter Häufigkeit ist hier die Anzahl der Durchschläge pro Zeit gemeint.

Die Staffelung des Warn- oder Störsignals kann sich dabei an einer empirisch ermittelte Exponentialfunktion der Durchschlagshäufigkeit orientieren. Auf diese Weise braucht bei einem einfachen Störfall noch nicht das entsprechende Betriebsmittel abgeschaltet werden. Gegebenenfalls kann der Betrieb auch über längere Zeit, gegebenenfalls mit geringfügigen Einschränkungen, aufrechterhalten werden. Diese Art der Überwachung kommt der Betriebsführung sehr entgegen, da nicht sofort ein Abschalten erforderlich ist.

Die Meßgenauigkeit der Erfassungseinrichtung 9 muß derart genau sein, daß ein Überschlag zwischen zwei Einlagen erfaßt werden kann. Bei einer Kondensatordurchführung mit beispielsweise 100 Einlagen würde der erste Teildurchschlag lediglich eine Spannungsänderung von 1 % bezogen auf die Gesamtspannung betragen. Gegebenenfalls muß die Erfassungseinrichtung 9 daher auch zusätzliche Mittel aufweisen, die eine Unterscheidung zwischen Überschlägen und sonstigen Spannungserhöhungen erlaubt, so daß Fehler in der Überwachung vermieden werden. Beispielsweise kann auch eine Grenzwertbearbeitung mit Hilfe eines Grenzwertgliedes durchgeführt werden.

Es kann auch in seltenen Fällen vorkommen, daß aufgrund von Materialmängeln der Schadensmechanismus nicht nach einer Exponentialfunktion verläuft. In einem solchen Fall kann beispielsweise eine lawinenartige Häufigkeit von Durchschlägen entweder früher auftreten oder gegebenenfalls durch ein Ausbrennen des Fehlerortes vermindert sein. In diesem Fall kann die Erfassungseinrichtung 9 auch ein nicht näher gezeigtes Fuzzy-Glied umfassen, das eine gewichtete Beurteilung oder Bewertung der Durchschlagshäufigkeit erlaubt, so daß auch von der Exponentialfunktion abweichende Fehlerfälle sicher erfaßt werden und zu einer entsprechenden Signalisierung oder auch Abschaltung führen können. Die abgespeicherten Informationen der Änderungen der Teilspannung werden dazu einer gewichteten Beurteilung unterzogen, bevor ein Fehlersignal erzeugt wird.

Gegebenenfalls können auch in der Erfassungseinrichtung 9 Daten über die Durchschlagshäufigkeit nach Art eines Abbilds oder Datenabbilds fest abgelegt sein, mit denen die neu auftretenden Durchschläge verglichen werden, um dann zu einer entsprechenden Signalisierung zu führen.

Die Erfassungseinrichtung 9 kann für die Betriebsführung Anzeigemittel, beispielsweise ein Display 11 umfassen, auf dem Betriebsfunktionen, Störmeldungen und sonstige Informationen mittels einer Tastatur 13 abrufbar sind. Die Tastatur 13 kann z. B. Taster 15 oder auch Einsteller 17 umfassen. Zur Störfallsignalisierung kann außer dem Display 11 auch zusätzlich noch ein optisches Signalmittel, z. B. eine Störungsanzeige 19, vorgesehen sein.

Weiterhin weist die Erfassungseinrichtung 9 einen Ausgang 21 auf, der als einfacher Störsignalausgang zur Weiterleitung des Störsignals oder auch als Schnittstelle zur Weitergabe beliebiger Informationen ausgebildet sein kann. Das entsprechende Signal oder die Informationen können dann an übergeordnete leittechnische Einrichtungen zur weiteren Bearbeitung weitergegeben werden.

Eine alternative Lösung sieht vor, daß lediglich die Änderungen der Teilspannung gezählt werden und nach einer vorgegebenen Anzahl von Änderungen das Fehlersignal erzeugt wird. Diese Lösung ist besonders einfach und läßt sich ggf. bei bestehenden Einrichtungen nachrüsten. Das Fehlersignal wird dabei ggf. erst nach Auftreten der Änderungen in einem vorgegebenen Zeitraum erzeugt. Damit liegt der Signalisierung eine Information über die Häufigkeit der Änderungen zugrunde. Eine Grenzwertbearbeitung der Teilspannungsänderung ist möglich. Eine für diese alternative Lösung geeignete Anordnung läßt sich mit wenig Aufwand in Anlehnung an die oben beschriebene realisieren.

Wesentlich für die vorliegende Idee ist, daß quasi eine statistische Auswertung der auftretenden Fehler erfolgt. Durch die Auswertung ist eine Abschätzung der Gefährlichkeit der/des Fehler/s für die Betriebssicherheit möglich.

## Patentansprüche

1. Überwachungsverfahren für eine Kondensatordurchführung (1), die zwischen ihren Kondensatoreinlagen einen Abgriff (3U,3V,3W) für eine Teilspannung aufweist,
- wobei die Teilspannung einer Erfassungseinrichtung (9) zugeführt wird, welche die Teilspannung auf eine Änderung hin überwacht,
- wobei eine Änderung der Teilspannung und eine Zeitinformation hierzu gespeichert werden,
- wobei der zeitliche Abstand zwischen zumindest zwei Änderungen ermittelt wird, und
- wobei ein der Häufigkeit der Teilspannungsänderungen entsprechendes Fehlersignal erzeugt wird.

2. Überwachungsverfahren nach Anspruch 1,
wobei die Speicherung der Änderung der Teilspannung nach Überschreiten eines vorgegebenen Grenzwertes erfolgt.

3. Überwachungsverfahren nach Anspruch 1 oder 2,
wobei das Fehlersignal nach einer vorgegebenen gewichteten Bewertung der gespeicherten Änderungen erzeugt wird.

4. Überwachungsverfahren nach Anspruch 1,2 oder 3,
wobei als Zeitinformation der Enstehungszeitpunkt der Änderung und/oder die Differenzzeit zwischen zwei Änderungen gespeichert sind/ist.

5. Überwachungsverfahren nach einem der Ansprüche 1 bis 4,
wobei die Überwachung der Teilspannung je Phase der Kondensatordurchführung (1) erfolgt.

6. Überwachungsverfahren nach einem der Ansprüche 1 bis 5,
wobei ein zeitliches Abbild der erfaßten Änderungen mit einem abgespeicherten Abbild eines vorgegebenen Fehlerfalls verglichen wird und wobei bei zumindest teilweiser Übereinstimmung das Fehlersignal erzeugt wird.

7. Überwachungsanordnung für eine Kondensatordurchführung (1), die zwischen ihren Kondensatoreinlagen einen Abgriff (3U,3V,3W) für eine Teilspannung aufweist, mit
- einer Erfassungseinrichtung (9), in der die Teilspannung auf eine Änderung hin überwacht wird, gekennzeichnet durch
- einen Speicher, in dem eine Änderung der Teilspannung und eine Zeitinformation hierzu hinterlegt werden,
- ein Rechenglied, mit dem der zeitliche Abstand zwischen zumindest zwei Änderungen ermittelt wird, und
- Mittel zum Erzeugen eines Fehlersignals, wobei ein der Häufigkeit der Teilspannungsänderungen entsprechendes Fehlersignal erzeugt wird.

8. Überwachungsanordnung nach Anspruch 7,
mit einem Grenzwertglied, wobei die Speicherung der Änderung der Teilspannung nach Überschreiten eines vorgegebenen Grenzwertes erfolgt.

9. Überwachungsanordnung nach Anspruch 7 oder 8,
mit einem Fuzzy-Glied, wobei das Fehlersignal nach einer vorgegebenen Gewichtung der gespeicherten Änderungen mit Hilfe des Fuzzy-Gliedes erzeugt wird.

10. Überwachungsanordnung nach Anspruch 7,8 oder 9, wobei die Erfassungseinrichtung ein- oder mehrphasig, insbesondere dreiphasig, ausgeführt ist.

11. Überwachungsverfahren für eine Kondensatordurchführung (1), die zwischen ihren Kondensatoreinlagen einen Abgriff (3U,3V,3W) für eine Teilspannung aufweist, wobei die Teilspannung einer Erfassungseinrichtung (9) zugeführt ist, welche die Teilspannung auf eine Änderung hin überwacht, wobei Änderungen der Teilspannung gezählt werden, und wobei nach einer vorgegebenen Anzahl von Änderungen ein Fehlersignal erzeugt wird.

12. Überwachungsverfahren nach Anspruch 11, wobei das Fehlersignal bei Auftreten der Änderungen in einem vorgegebenen Zeitraum erzeugt wird.

13. Überwachungsverfahren nach Anspruch 12, wobei die Zählung einer Änderung der Teilspannung nach Überschreiten eines vorgegebenen Grenzwertes für die Teilspannung erfolgt.

14. Überwachungsanordnung für eine Kondensatordurchführung (1), die zwischen ihren Kondensatoreinlagen einen Abgriff (3U,3V,3W) für eine Teilspannung aufweist, mit
- einer Erfassungseinrichtung (9), in der die Teilspannung auf eine Änderung hin überwacht wird, gekennzeichnet durch
- eine Zähleinrichtung, mit der Änderungen der Teilspannung gezählt werden, und
- Mittel zum Erzeugen eines Fehlersignals, wobei das Fehlersignal nach Überschreiten einer vorgegebenen Anzahl von Änderungen erzeugt wird.

## Claims

1. Method for monitoring a capacitor bushing (1) which has a tap (3U,3V,3W) for a component voltage between its capacitor inserts,
- wherein the component voltage is fed to a detection device (9) which monitors the component voltage for any change;
- wherein a change in the component voltage and time information relating thereto are stored;
- wherein the time interval between at least two changes is determined; and
- wherein an error signal corresponding to the frequency of the changes in the component voltage is generated.

2. Monitoring method according to claim 1, wherein the change in the component voltage is stored after a given limiting value has been exceeded.

3. Monitoring method according to claim 1 or 2, wherein the error signal is generated after a given weighted assessment of the stored changes.

4. Monitoring method according to claim 1, 2 or 3, wherein the instant at which the change occurs and/or the differential time between two changes are/is stored as time information.

5. Monitoring method according to one of claims 1 to 4, wherein the component voltage is monitored for each phase of the capacitor bushing (1).

6. Monitoring method according to one of claims 1 to 5, wherein a chronological image of the detected changes is compared with a stored image of a given case of an error and wherein the error signal is generated if there is at least partial agreement.

7. Arrangement for monitoring a capacitor bushing (1) which has a tap (3U,3V,3W) for a component voltage between its capacitor inserts, having
- a detection device (9) in which the component voltage is monitored for a change, characterised by
- a memory, in which a change in the component voltage and time information relating thereto are stored;
- a computational element, with which the time interval between at least two changes is determined; and
- means for generating an error signal, in which case an error signal is generated that corresponds to the frequency of the changes in the component voltage.

8. Monitoring arrangement according to claim 7, having a limiting-value element, wherein the change in the component voltage is stored after a given limiting value has been exceeded.

9. Monitoring arrangement according to claim 7 or 8, having a fuzzy element, wherein the error signal is generated after the stored changes have been weighted in a given way with the aid of the fuzzy element.

10. Monitoring arrangement according to claim 7, 8 or 9, wherein the detection device is realized as a single-phase or multi-phase, in particular a three-phase, system.

11. Method for monitoring a capacitor bushing (1) which has a tap (3U,3V,3W) for a component voltage between its capacitor inserts, wherein the component voltage is fed to a detection device (9) which monitors the component voltage for any change, wherein changes in the component voltage are counted, and wherein after a given number of changes an error signal is generated.

12. Monitoring method according to claim 11, wherein the error signal is generated when the changes occur within a given time period.

13. Monitoring method according to claim 12, wherein the changes in the component voltage are counted after a given limiting value for the component voltage has been exceeded.

14. Arrangement for monitoring a capacitor bushing (1) which has a tap (3U,3V,3W) for a component voltage between its capacitor inserts, having
- a detection device (9) in which the component voltage is monitored for a change, characterised by
- a counting device, with which changes in the component voltage are counted; and
- means for generating an error signal, in which case the error signal is generated after a given number of changes has been exceeded.

## Revendications

1. Procédé de surveillance d'une traversée de condensateur (1) qui comporte entre ses éléments formant condensateurs une prise (3U, 3V, 3W) pour une tension partielle,
- dans lequel on envoie la tension partielle à un dispositif de détection (9) qui surveille la tension partielle pour détecter une variation,
- dans lequel on mémorise une variation de la tension partielle et une information temporelle associée,
- dans lequel on détermine l'intervalle de temps entre au moins deux variations, et
- dans lequel on produit un signal d'erreur correspondant à la fréquence des variations de la tension partielle.

2. Procédé de surveillance selon la revendication 1, dans lequel la mémorisation de la variation de la tension partielle s'effectue après dépassement d'une valeur limite prescrite.

3. Procédé de surveillance selon la revendication 1 ou 2, dans lequel on produit le signal d'erreur après une évaluation pondérée prescrite des variation mémorisées.

4. Procédé de surveillance selon la revendication 1, 2 ou 3, dans lequel on mémorise comme information temporelle l'instant d'apparition de la variation et/ou l'intervalle de temps entre deux variations.

5. Procédé de surveillance selon l'une des revendications 1 à 4, dans lequel la surveillance de la tension partielle s'effectue pour chaque phase de la traversée de condensateur (1).

6. Procédé de surveillance selon l'une des revendications 1 à 5, dans lequel on compare une image temporelle des variations détectées à une image mémorisée d'un cas d'erreur prescrit et dans lequel on produit le signal d'erreur pour une coïncidence au moins partielle.

7. Dispositif de surveillance d'une traversée de condensateur (1) qui comporte entre ses éléments formant condensateurs une prise (3U, 3V, 3W) pour une tension partielle, comprenant
- un dispositif de détection (9), dans lequel la tension partielle est surveillée pour détecter une variation, caractérisé par :
- une mémoire dans laquelle une variation de la tension partielle et une information temporelle associée sont mémorisées,
- un élément de calcul par lequel l'intervalle de temps entre au moins deux variations est déterminé, et
- des moyens destinés à produire un signal d'erreur, un signal d'erreur correspondant à la fréquence des variations de la tension partielle étant produit.

8. Dispositif de surveillance selon la revendication 7, comportant un élément à valeur limite, dans lequel la mémorisation de la variation de la tension partielle s'effectue après dépassement d'une valeur limite prescrite.

9. Dispositif de surveillance selon la revendication 7 ou 8, comportant un élément à logique floue, dans lequel le signal d'erreur est produit à l'aide de l'élément à logique floue après une pondération prescrite des variations mémorisées.

10. Dispositif de surveillance selon la revendication 7, 8 ou 9, dans lequel le dispositif de détection est conçu monophasé ou polyphasé, notamment triphasé.

11. Procédé de surveillance d'une traversée de condensateur (1) qui comporte entre ses élémemts formant condensateurs une prise (3U, 3V, 3W) pour une tension partielle, dans lequel on envoie la tension partielle à un dispositif de détection (9) qui surveille la tension partielle pour détecter une variation, dans lequel on compte des variations de la tension partielle et dans lequel on produit un signal d'erreur après un nombre prescrit de variations.

12. Procédé de surveillance selon la revendication 11, dans lequel on produit le signal d'erreur lors de l'apparition des variations pendant un intervalle de temps prescrit.

13. Procédé de surveillance selon la revendication 12, dans lequel on effectue le comptage d'une variation de la tension partielle après dépassement d'une valeur limite prescrite pour la tension partielle.

14. Dispositif de surveillance d'une traversée de condensateur (1) qui comporte entre ses éléments formant condensateurs une prise (3U, 3V, 3W) pour une tension partielle, comprenant
- un dispositif de détection (9), dans lequel la tension partielle est surveillée pour détecter une variation, caractérisé par :
- un dispositif de comptage par lequel des variations de la tension partielle sont comptées, et
- des moyens destinés à produire un signal d'erreur, le signal d'erreur étant produit après dépassement d'un nombre prescrit de variations.
